# EUROPEAN PATENT APPLICATION

(11) **EP 1 434 091 A1**
(43) Date of publication of application: **30.06.2004**
(21) Application number: 02800236.8
(22) Date of filing: 24.09.2002
(51) Int. Cl.: G03F 7/039, G03F 7/004, H01L 21/027

(54) **CHEMICAL-AMPLIFICATION-TYPE POSITIVE RADIATION-SENSITIVE RESIN COMPOSITION**

(30) Priority: 28.09.2001 JP 2001300457
(71) Applicant: Clariant International Ltd., 4132 Muttenz (CH)
(72) Inventor: HAMADA, Takahiro c/o Clariant(Japan)K.K., Daitocho, Ogasa-gun, Shizuoka 437-1496 (JP); LEE, Dong Kwan c/o Clariant Corporation, Somerville, NJ 08876 (US); MIYAZAKI, Shinji c/o Clariant(Japan)K.K., Daitocho, Ogasa-gun, Shizuoka 437-1496 (JP)
(74) Representative: Hütter, Klaus, Dr.
(86) International application number: PCT/JP2002/009744
(87) International publication number: WO 2003/029901

(57) **Abstract**

In a positive-working chemically amplified radiation sensitive resin composition with high sensitivity and high resolution comprising an alkali-insoluble or slightly alkali-soluble resin protected with an acid-labile protecting group and an acid generating compound upon irradiation with radiation, a difference of resolution line widths of isolated and dense patterns in a circuit pattern, in which an isolated pattern and a dense pattern are mixed, can be reduced by using a resin having activation energy (ΔE) to make the protecting group cleaved of 25 Kcal/mole or higher as the alkali-insoluble or slightly alkali-soluble resin protected with an acid-labile protecting group, and a mixture of a compound generating a carboxylic acid upon irradiation with radiation and a compound generating a sulfonic acid upon irradiation with radiation as the acid generator.

## Description

### Technical Field of Invention

The present invention relates to a chemically amplified positive-working radiation sensitive resin composition that can be favorably applied for a photoresist in the fine processing when manufacturing electronic parts such as a semiconductor, a three-dimensional fine structure, etc.

### Background art

In the fine processing when manufacturing electronic parts such as a semiconductor, a three-dimensional fine structure, etc., a photolithography process is so far being applied in general. In the photolithography process, positive- or negative-working radiation sensitive resin compositions are used to form a resist pattern. Among these radiation sensitive resin compositions, a radiation sensitive resin composition comprising an alkali-soluble resin and a quinone diazide compound, which is a photosensitizer, is widely utilized.

By the way, as LSI is getting highly integrated and in high speed recently, fining of half micron or quarter micron of design rule is being required in the manufacturing field of fine electronic devices. In order to respond to a further fining of such design rule, light sources so far applied such as visible light, ultra violet light (wavelength 400 - 300 nm), etc. are not sufficient and then there is required to use as light sources deep ultra violet light such as KrF eximer laser (248 nm), ArF eximer laser (193 nm), etc., and radiation with shorter wavelength such as X-ray, electron beams, etc. Lithography processes to use these light sources are being proposed and are being used practically.

In order to respond this fining of the design rule a high resolution is required to a radiation sensitive resin composition that is used as a photoresist upon the fine processing. Furthermore improvement of performance such as sensitivity and accuracy of image dimension is also being required besides the high resolution to the radiation sensitive resin composition in the same time. In this situation, "a chemically amplified radiation sensitive resin composition" is being proposed as a radiation sensitive resin composition with high resolution that is sensitive to radiation of short wavelength. The chemically amplified radiation sensitive resin composition contains a compound generating an acid (acid generator) upon irradiation with radiation and an acid is generated from the acid generating compound when irradiated by radiation. As it is advantageous that high sensitivity can be obtained by a catalytic image-forming process based on the generated acid, the chemically amplified radiation sensitive resin composition is replacing the radiation sensitive resin composition so far applied to be diffusing.

There are positive and negative-working types for the chemically amplified radiation sensitive resin composition in the same way as the radiation sensitive resin composition so far applied. As a positive-working chemically amplified radiation sensitive resin composition, a two-component system comprising a base resin and an acid generator and a three-component system comprising a base resin, an acid generator and a dissolution inhibitor having an acid-labile group are well known. And then many radiation sensitive resin compositions comprising a base resin derived from a polyhydroxystyrene resin or the like are being reported as a chemically amplified radiation sensitive resin composition. As such base resins derived from a polyhydroxystyrene resin, for example, resins were reported in which the phenolic hydroxyl groups are protected partially or totally with a protecting group which can be cleaved by an acid such as a t-butoxycarbonyl group (US Patent No. 4,491,628, and US Patent No. 5,403,695), a t-butyl group, a trimethylsilyl group, a tetrahydropyranyl group (US Patent No. 5,350,660), a 2-(alkoxyethyl) group (US Patent No. 5,468,589) or a mixture thereof. Further, two or three component copolymer resins comprising hydroxystyrene and acrylic acid or methacrylic acid, the carboxylic acids of which are partially or totally protected with a protecting group, which can be cleaved by acid, such as a t-butyl group (US Patent No. 4,491,628 and US Patent No. 5,482,816), an amyl group or a tetrahydropyranyl group, were also reported as useful ones. Furthermore for example in Japanese Unexamined Patent Publication No. Hei 11-125907, a t-butyl group, a t-butoxycarbonyl methyl group, a t-butoxycarbonyl group, a 1-methixyethyl group, a 1-ethoxyethyl group, etc. are raised as an acid-labile group of acid-labile group-containing resin in a positive-working chemically amplified resist.

On the other hand, as a negative-working chemically amplified resin composition, ones comprising a base resin, an acid generator and a crosslinking agent, wherein a combination of the crosslinking agent and the alkali-soluble resin is for example a combination of hexamethoxymethyl melamine and an alkali-soluble phenol resin (US Patent No. 5,376,504 and US Patent No. 5,389,491), etc. were reported.

And moreover as an acid generator which is used for a chemically amplified positive or negative-working photoresist, ionic onium salts, particularly hexafluoro antimonate and trifluoromethane sulfonate (US Patent No. 5,569,784), aliphatic/aromatic sulfonate (US Patent No. 5,624,787), and an iodonium salt or sulfonium salt with a strong non-nucleophilic anion such as an aforementioned compound (US Patent No. 4,058,400, and US patent No. 4,933,377), etc. were reported. And it is also proposed that an acid generator which generates some kind of halogenated hydrogen is effective for negative-working photoresist (US Patent No. 5,599,949). Furthermore in Japanese Unexamined Patent Publication No. Hei 11-125907, it is also proposed to use an acid generator consisting of a combination of "a compound which generates carboxylic acid, boiling point of which is 150° C or higher upon irradiation with radiations" and "a compound which generates acid other than carboxylic acid". From the view point of improving properties of the chemically amplified radiation sensitive resin composition, a lot of improvements concerning a resin, an acid generator, etc. are being made and the chemically amplified radiation sensitive resin composition is being practically used.

However degree of integration of integrated circuit of semiconductor device is getting higher year by year and with this higher integration, higher resolution is being required. As a result, a difference of resolution line widths of isolated and dense patterns formed (a difference between an isolated pattern and a dense pattern) is getting problematic in a circuit pattern wherein isolated and dense patterns exist in a mixture. The difference of resolution line widths of isolated and dense patterns formed is large in a chemically amplified positive-working resist so far proposed, and the reduction of the difference of resolution line widths is getting an important problem to be solved from a view point of obtaining a resist pattern as designed.

Although OPC (Optical Proximity Correction) is known as a method to reduce the generation of a difference between an isolated pattern and a dense pattern, OPC has a difficult point upon preparation of a mask as well as the increasing of the manufacturing cost and data processing volume. It means that as OPC so far applied requires the correction by adding a minute pattern (decoration pattern) on a mask, there is a difficult point that this minute pattern is recognized as a mask defect or the size of the minute pattern becomes below the resolution limit of a mask pattern.

Further in Japanese Unexamined Patent Publication No. Hei 11-125907, it is described that a pattern formation without causing "film face roughness" is possible by using an alkali-soluble or slightly alkali-soluble resin protected by an acid-labile protecting group and an acid generator consisting of a combination of "a compound which generates carboxylic acid, boiling point of which is 150°C or higher, by irradiation of radiations" and "a compound which generates acid other than carboxylic acid". However there is no description in the publication that a selection of resin is conducted on basis of the activation energy (ΔE) to make an acid-labile protecting group cleaved and that a difference of resolution line widths of the isolated and dense patterns of photoresist (a difference between an isolated pattern and a dense pattern) is improved by a combination of the selected resin and a specific acid generator.

Under the circumstances described above, the purpose of the present invention is to provide a positive-working chemically amplified radiation sensitive resin composition that has good sensitivity and high resolution besides a small difference of resolution line widths of isolated and dense patterns (difference between an isolated pattern and a dense pattern) when used as a chemically amplified photoresist in manufacturing a semiconductor etc.

### Disclosure of the Invention

As a result of eager study and examination, the present inventors found that the above-described object can be attained by limiting activation energy (ΔE) to make an acid-labile protecting group of an alkali-insoluble or slightly alkali-soluble resin protected with an acid-labile protecting group cleaved in the determined range and by using a mixture of a compound generating a carboxylic acid and a compound generating a sulfonic acid both upon irradiation with radiations as an acid generator in a positive-working chemically amplified radiation sensitive resin composition, which is useful as the photoresist, containing an alkali-insoluble or slightly alkali-soluble resin protected with an acid-labile protecting group and an acid generator and reached to the present invention.

It means that the present invention relates to a positive-working chemically amplified radiation sensitive resin composition which is characterized in that it comprises (A) an alkali-insoluble or slightly alkali-soluble resin protected with an acid-labile protecting group and made alkali-soluble by cleavage of said acid-labile protecting group, activation energy (ΔE) of the cleavage being 25 Kcal/mole or higher, (B) a compound generating a carboxylic acid upon irradiation with radiation, and (C) a compound generating a sulfonic acid upon irradiation with radiation.

Hereinafter, the present invention will be described further in more detail.

In the present invention, as an alkali-insoluble or slightly alkali-soluble resin protected with an acid-labile protecting group which is made alkali-soluble by cleavage of said acid-labile protecting group, a resin is used of which activation energy (ΔE) to make said acid-labile protecting group cleaved is 25 Kcal/mole or higher. As those kinds of resin, one which meets the above-described condition may be selected and used among the alkali-insoluble or slightly alkali-soluble resins so far used in a positive-working chemically amplified resist, in which a group to make the resin alkali-soluble is protected partially by a protecting group being able to be cleaved by an acid.

The alkali-insoluble or slightly alkali-soluble resins in which a group to make the resin alkali-soluble is protected partially by a protecting group which can be cleaved by an acid, can be exemplified with (1) a reaction product between (a) a homopolymer of hydroxystyrenes, a copolymer of hydroxystyrene and other monomers, or phenol resin and (b) a vinyl ether compound or a dialkyl dicarbonate (Carbon number of the alkyl group is 1 to 5.), (2) a homopolymer of a reaction product of hydroxystyrene with a vinyl ether compound or a dialkyl dicarbonate (Carbon number of the alkyl group is 1 to 5.) or a copolymer of the reaction product and the other monomer, or (3) one wherein a protecting group in these homopolymer and copolymer having a group protected by a protecting group is partially cleaved, if necessary, by an acid.

Hydroxystyrenes used for manufacturing these polymers are preferably exemplified with 4-hydroxystyrene, 3-hydroxystyrene and 2-hydroxystyrene. The 4-, 3- or 2-hydroxystyrene is made poly(4-hydroxystyrene), poly(3-hydroxystyrene) and poly(2-hydroxystyrene) by homopolymerization as described above or is made a two or three component copolymer by copolymerization with the other monomer followed by introduction of a protecting group to produce an alkali-insoluble resin; or 4-, 3- or 2-hydroxystyrene protected by the protecting group is copolymerized with an other monomer or monomers to be made an alkali-insoluble resin. Furthermore an alkali-insoluble resin may be produced by cleaving with an acid a part of a protecting group of an alkali-insoluble resin having a protecting group produced as described above.

Other monomers which are copolymerized with hydroxystyrenes in order to produce above-described copolymers can be exemplified for example with styrene, 4-, 3- or 2-acetoxystyrene, 4-, 3- or 2-alkoxystyrene, α-methylstyrene, 4-, 3- or 2-alkylstyrene, 3-alkyl-4-hydroxystyrene, 3,5-dialkyl-4-hydroxystyrene, 4-, 3- or 2-chlorostyrene, 3-chloro-4-hydroxystyrene, 3,5-dichloro-4-hydroxystyrene, 3-bromo-4-hydroxystyrene, 3,5-dibromo-4-hydroxystyrene, vinylbenzyl chloride, 2-vinylnaphtharene, vinylanthracene, vinylaniline, vinylbenzoic acid, vinylbenzoic acid esters, N-vinylpyrrolidone, 1-vinylimidazol, 4- or 2-vinylpyridine, 1-vinyl-2-pyrrolidone, N-vinyllactam, 9-vinylcarbazol, acrylic acid, acrylic ester and their derivatives, methacrylic acid, methacrylic ester and their derivatives, for example methylmethacrylate and its derivatives, methacrylamide and its derivatives, acrylonitril, methacrylonitril, 4-vinylphenoxy acetic acid and its derivatives, for example, 4-vinylphenoxy acetic acid esters, maleimide and its derivatives, N-hydroxymaleimide and its derivatives, maleic anhydride, maleic acid or fumaric acid and its derivatives, for example, maleic or fumaric esters, vinyltrimethylsilane, vinyltrimethoxylsilane, vinylnorbornen and its derivatives, etc.

Furthermore other monomers can be preferably exemplified with isopropenylphenol, propenylphenol, (4-hydroxyphenyl) acrylate or -methacrylate, (3-hydroxyphenyl) acrylate or -methacrylate, (2-hydroxyphenyl) acrylate or -methacrylate, N-(4-hydroxyphenyl) acrylamide or -methacrylamide, N-(3-hydroxyphenyl) acrylamide or -methacrylamide, N-(2-hydroxyphenyl) acrylamide or -methacrylamide, N-(4-hydroxybenzyl) acrylamide or -methacrylamide, N-(3-hydroxybenzyl) acrylamide or -methacrylamide, N-(2-hydroxybenzyl) acrylamide or-methacrylamide, 3-(2-hydroxy-hexafluoropropyl-2)styrene, 4-(2-hydroxy-hexafluoropropyl-2)styrene, etc.

Vinyl ether compounds which form a protecting group cleaved with an acid by modifying a group providing alkali-solubility to a resin are preferably exemplified with n-butylvinyl ether, t-butylvinyl ether, etc. These vinyl ether compounds can be used singly or in a combination of two or more kinds.

Dialkyl carbonates are preferably exemplified with di-t-butyl dicarbonate.

Among the above-described resins, one represented by the following general formula (I) is raised as an example of a preferable resin. 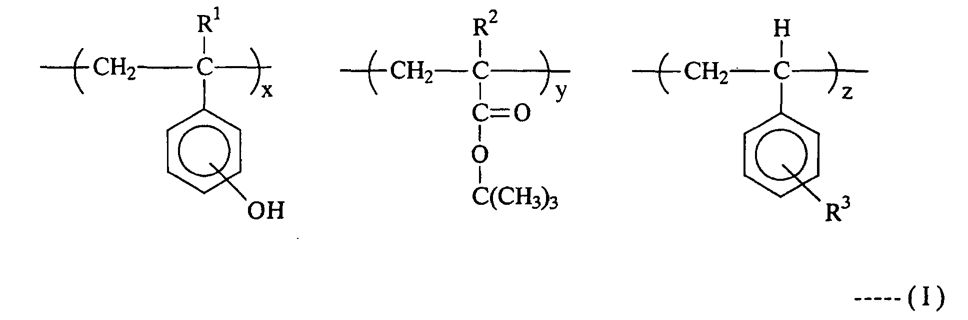 Wherein R¹ and R² represent a hydrogen atom or a methyl group, each individually, R³ represents a hydrogen atom, a t-butoxy group or -O-C(R⁴)₂-O-C(R⁵)₃ (R⁴ and R⁵ may be the same or different from each other and represent a hydrogen atom, a methyl group or a ethyl group.), X, y and z each represents a number in recurring unit, x and y are integers of 1 or more and z is 0 or an integer of 1 or more.

As the resin represented by the above general formula (I), a terpolymer of p-hydroxystyrene, t-butyl methacrylate or t-butyl acrylate, and styrene or t-butoxystyrene is preferable.

As the above-described resin which is made alkali-insoluble or slightly alkali-soluble, a polymer, the basic structure of which is hydroxystyrene is preferable, however its structure is not particularly limited and a resin, of which the activation energy (ΔE) to cleave said acid-labile protecting group is not less than 25 Kcal/mole may be selected considering the using purpose, a light-exposure wavelength, a manufacturing condition of a resin or a composition, and a constitution of the composition. Hereby when a resin of which the activation energy (ΔE) to cleave the protecting group is not less than 25 Kcal/mole is classified with a protecting group or a comonomer, poly(p-hydroxystyrene) having a protecting group of t-butyl group, t-butoxyalkyl group, t-butoxycarbonyl group, or t-butoxycarbonylalkyl group or a copolymer produced using t-butyl methacrylate as a comonomer are raised. ΔE value is a calculated value by PM3 MO (Molecular Orbital) method using MOPAC93. This is described, for example in Proc. 10^{th} International Conference on Photopolymer: Principles, Process and Materials, Society of Plastics Engineering, Mid-Hudson Section (1994) 11-17, Journal of Photopolymer Science and Technology, Volume 12, No. 4 (1999) 607-620, Journal of Photopolymer Science Part A: Poly. Chem. (1998) 36(7), Proc. SPIE-Int. Soc. Opt. Eng. (1999) 3678, 608-616 and ΔE values for some groups and compounds are described in these literatures. In the present invention ΔE values can be distinguished referring to the values described in these literatures.

On the other hand, (B) a compound generating a carboxylic acid upon irradiation with radiation and (C) a compound generating a sulfonic acid upon irradiation with radiation are contained as acid generators in the present invention. As a compound (B) generating a carboxylic acid upon irradiation with radiation of the present invention, any one of compounds which generates a carboxylic acid upon irradiation with radiation can be used including the compounds which are so far known as an acid generator generating a carboxylic acid upon irradiation with radiation in a chemically amplified resist. These compounds generating a carboxylic acid upon irradiation with radiations can be exemplified with diphenyl-2,4,6-trimethylphenylsulfonium pentadecafluoroheptan carboxylate, diphenyl-2,4,6-trimethylphenyl-4-trifluoromethylbenzene carboxylate, triphenylsulfonium trifluoromethane carboxylate, triphenylsulfonium pentafluoroethane carboxylate, triphenylsulfonium pentadecafluoroheptane carboxylate, triphenylsulfonium tricosafluoroundecane carboxylate, triphenylsulfonium heptane carboxylate, diphenyl-4-trimethylphenylsulfonium pentadecafluoroheptane carboxylate, etc.

As a compound (C) generating a sulfonic acid upon irradiation with radiations of the present invention, any one of compounds which generates a sulfonic acid upon irradiation with radiation can be used including the compounds which are so far known as an acid generator generating a sulfonic acid upon irradiation with radiation in a chemically amplified resist. These compounds generating a sulfonic acid upon irradiation with radiation can be exemplified with sulfonium salt compounds such as triphenylsulfonium methane sulfonate, triphenylsulfonium trifluoromethane sulfonate, triphenylsulfonium propane sulfonate, triphenylsulfonium hexafluoropropane sulfonate, triphenylsulfonium nonafluorobutane sulfonate, triphenylsulfonium phenyl sulfonate, triphenylsulfonium 4-methylphenyl sulfonate, triphenylsulfonium 4-methoxyphenyl sulfonate, triphenylsulfonium p-chlorophenyl sulfonate, triphenylsulfonium camphor sulfonate, 4-methylphenyldiphenylsulfonium trifluoromethane sulfonate, bis-(4-methylphenyl)-phenylsulfonium trifluoromethane sulfonate, tris-4-methylphenylsulfonium trifluoromethane sulfonate, 4-t-butylphenyl-diphenylsulfonium trifluoromethane sulfonate, 4-methoxyphenyl-diphenylsulfonium trifluoromethane sulfonate, mesityldiphenylsulfonium trifluoromethane sulfonate, 4-chlorophenyl-diphenylsulfonium trifluoromethane sulfonate, bis-(4-chlorophenyl)-phenylsulfonium trifluoromethane sulfonate, tris-(4-chlorophenyl)-sulfonium trifluoromethane sulfonate, 4-methylphenyl-diphenylsulfonium hexafluoropropane sulfonate, bis(4-methylphenyl)phenylsulfonium hexafluoropropane sulfonate, tris-4-methylphenylsulfonium hexafluoropropane sulfonate, 4-t-butylphenyl-diphenylsulfonium hexafluoropropane sulfonate, 4-methoxyphenyl-diphenylsulfonium hexafluoropropane sulfonate, mesityl-diphenylsulfonium hexafluoropropane sulfonate, 4-chlorophenyl-diphenylsulfonium hexafluoropropane sulfonate, bis-(4-chlorophenyl)-phenylsulfonium hexafluoropropane sulfonate, tris-(4-chlorophenyl)-sulfonium hexafluoropropane sulfonate, triphenylsulfonium naphthalene sulfonate; iodonium salt compounds such as diphenyliodonium trifluoromethane sulfonate, diphenyliodonium hexafluoropropane sulfonate, diphenyliodonium p-4-methylphenyl sulfonate, bis-(p-t-butylphenyl)iodonium trifluoromethane sulfonate, bis-(p-t-butylphenyl)iodonium hexafluoropropane sulfonate, bis-(p-cyclohexylphenyl)iodonium trifluoromethane sulfonate, bis-(p-cyclohexylphenyl)iodonium hexafluoropropane sulfonate, diphenyliodonium pyrene sulfonate, diphenyliodonium dodecylbenzene sulfonate; etc.

These acid generators are used in a mixture of two kinds or more of at least one kind of a compound (B) generating a carboxylic acid upon irradiation with radiation and at least one kind of a compound (C) generating a sulfonic acid upon irradiation with radiation, and are required to be the combination of a compound generating a weak acid, showing positive value of pKa (ionization constant of acid), upon irradiation with radiation and a compound generating a strong acid, showing negative value of pKa, upon irradiation with radiation. Thereby an occurrence of standing wave upon a formation of a resist pattern can be restrained, furthermore the aforementioned difference of resolution line widths between an isolated pattern and a dense pattern (a difference of isolated and dense) can be controlled. Herewith the aforementioned compound generating a carboxylic acid upon irradiation with radiation is a compound generating a weak acid showing positive pKa and the aforementioned compound generating a sulfonic acid upon irradiation with radiation is a compound generating a strong acid showing negative pKa. And then the compound generating a carboxylic acid upon irradiation with radiation is used at the amount of 1.0 to 100 mole-%, preferably 3.0 to 50 mole-%, more preferably 6.0 to 25 mole-% relative to the compound generating a sulfonic acid upon irradiation with radiation. On the other hand, the compound generating a sulfonic acid upon irradiation with radiation is usually used at the amount of 5 to 300 µmole/g, preferably 10 to 150 µmole/g relative to an alkali-insoluble or slightly alkali-soluble resin protected by an acid-labile protecting group.

A basic compound is preferably incorporated in the positive-working chemically amplified radiation sensitive resin composition of the present invention as an additive. The basic compound controls a diffusion phenomenon in a resist film of an acid generated from an acid generator upon exposure to light, and can improve the resolution or can improve the latitude of exposure to light, etc. These basic compounds can be exemplified with primary, secondary or tertiary aliphatic amines, aromatic amines, heterocyclic amines, nitrogen compounds having an alkyl group, an aryl group, etc. , compounds having an amide group or an imide group, etc.

In the present invention, an alkali-insoluble or slightly alkali-soluble resin protected by an acid-labile protecting group, an acid generator, etc. are dissolved in a solvent/solvents and the solution obtained is used as a positive-working chemically amplified radiation sensitive resin composition. As solvents in which those components of the positive-working chemically amplified radiation sensitive resin composition are dissolved, there can be preferably exemplified ethylene glycol monoalkyl ethers such as ethylene glycol monomethyl ether, ethylene glycol monoethyl ether, etc.; ethylene glycol monoalkyl ether acetates such as ethylene glycol monomethyl ether acetate, ethylene glycol monoethyl ether acetate, etc.; propylene glycol monoalkyl ethers such as propylene glycol monomethyl ether, propylene glycol monoethyl ether, etc.; propylene glycol monoalkyl ether acetates such as propylene glycol monomethyl ether acetate, propylene glycol monoethyl ether acetate, etc.; lactic esters such as methyl lactate, ethyl lactate, etc.; aromatic hydrocarbons such as toluene, xylene, etc.; ketones such as methyl ethyl ketone, 2-heptanone, cyclohexanone, etc.; amides such as N,N-dimethylacetamide, N-methylpyrrolidone, etc.; lactones such as γ-butyrolactone, etc.; and the like. These solvents may be used alone or in combination of two or more thereof.

In the radiation sensitive resin composition of the present invention, there may be incorporated, if necessary, dyes, adhesion aids, surfactants, etc. Examples of the dyes include Methyl Violet, Crystal Violet, Malachite Green, etc., examples of the adhesion aids include hexamethyldisilazane, chloromethylsilanes, etc., and examples of the surfactants include nonionic surfactants such as polyglycols and the derivatives thereof, i.e., polypropylene glycol or polyoxyethylene lauryl ether; fluorine-containing surfactants such as Fluorad (trade name; product of Sumitomo 3M Co., Ltd.), Megafac (trade name; product of Dai-Nippon Ink & Chemicals, Inc.), Surflon (trade name; product of Asahi Glass Company, Ltd.) and organosiloxane surfactants such as KP341 (trade name; product of Shin-Etsu Chemical Co., Ltd).

A formation of a resist pattern using the positive-working chemically amplified radiation sensitive resin composition of the present invention may follow the methods so far known in publicity. One example is that on a substrate made of silicon having thereon a silicon oxide film, a film of metal such as aluminum, molybdenum, chromium, a film of metal oxide such as ITO, etc., if necessary or further on which a circuit pattern or a semiconductor device is additionally formed, the positive-working chemically amplified radiation sensitive resin composition is applied by the proper method so far publicly known such as a spin coat method, a roll coat method, a land coat method, a flow-spread coat method, a dip coat method to form a photoresist thin film and the photoresist film is prebaked (for example, baking temperature at 70 - 150°C for 1 minute), if necessary. Then the photoresist film formed is usually pattern wise exposed to light through a mask for exposure to light such as a reticle. The exposure to light of photoresist film is generally conducted by deep ultra-violet light such as KrF excimer laser or ArF excimer laser, X-ray, electron beams, etc. After exposure to light, post exposure bake (PEB) is conducted (for example, baking temperature at 50 - 150°C), if necessary. After development of the photoresist film exposed to light, baking after development is conducted, if necessary (for example, baking temperature at 60 - 120° C) to form a resist pattern. A developer used at this moment may be any one of developers which can develop a positive-working chemically amplified radiation sensitive resin composition and there are exemplified a developer comprising an alkali aqueous solution as the developer. Furthermore as a developing method, a method so far applied for developing a photoresist such as a paddle development may be applied. Etching is conducted using the resist pattern formed in this way as a mask and a fine processing of a substrate is made thereby.

### Best mode for practicing the Invention

The present invention will now be described more specifically by reference to Examples which, however, are not to be construed to limit the present invention in any way. The evaluation method for isolated and dense patterns, an alkali-insoluble or slightly alkali-soluble resin (A) protected with an acid-labile protecting group, a compound (B) generating a carboxylic acid upon irradiation with radiation, and a compound (C) generating a sulfonic acid upon irradiation with radiation in the Examples and the Comparative Examples below are shown as follows.

### Evaluation method for isolated and dense patterns

A radiation sensitive resin composition was applied by a spin coating method on a 6-inch silicon wafer, and the coated film was prebaked at 100° C for 90 seconds on a hot plate to obtain a resist film of 0.4 µm in thickness. The film thickness was measured by the film thickness measuring equipment (Lambda Ace) produced by Dai-Nippon Screen Company. Next the resist film was exposed to light by changing an exposure quantity stepwise with a stepper, FPA3000EX5 (wavelength 248 nm) produced by Canon company using a half tone phase shift mask of a contact hole with 0.23 µm diameter/a space with 0.72 µm width for a isolated pattern and a contact hole with 0.23 µm diameter/a space with 0.27 µm width for a dense pattern. Then the resist film exposed to light was treated by heating on a hot plate at 120° C for 90 seconds. After the heating treatment, the resist film was paddle developed at 23°C for 1 minute using alkali-developer, AZ 300MIF Developer (2.38 weight % tetramethylammonium hydroxide aqueous solution) ("AZ" is a registered trademark) produced by Clariant Japan company to obtain a positive resist pattern. And then the hole diameters of isolated and dense patterns at an optimal light exposure quantity were measured by a scanning electronic microscope in a contact hole with 0.18 µm designed line width and from the difference, a difference of resolution line widths of isolated and dense patterns, ΔCD was calculated.

### (A) An alkali-insoluble or slightly alkali-soluble resin protected with an acid-labile protecting group

A-1: poly(p-hydroxystyrene-co-styrene-co-t-butyl methacrylate)
   ΔE ≒ 35 kcal/mole
A-2: poly(p-hydroxystyrene-co-t-butoxystyrene-co-t-butyl methacrylate)
   ΔE > 29 kcal/mole
A-3: poly(p-hydroxystyrene-co-t-butoxystyrene)
   ΔE > 29 kcal/mole
A-4: poly(p-hydroxystyrene-co-t-butoxycarbonylstyrene)
   ΔE ≒ 29 kcal/mole
A-5: poly[p-hydroxystyrene-co-p-(1-ethoxyethoxy)styrene)
   ΔE ≒ 22 kcal/mole

### (B) Compound generating a carboxylic acid upon irradiation with radiation

B-1: triphenylsulfonium pentadecafluoroheptane carboxylate
B-2: triphenylsulfonium trifluoromethane carboxylate

### (C) Compound generating a sulfonic acid upon irradiation with radiation

C-1: triphenylsulfonium nonafluorobutane sulfonate
C-2: triphenylsulfonium trifluoromethane sulfonate

### Example 1

After 50.0 µmole/g of C-1 relative to A-1 and 20.0 mole-% of B-1 relative to C-1 were mixed, triethanol amine as a basic substance and a surface active agent were added thereto. The mixture was dissolved in propylene glycol monomethyl ether acetate to prepare a positive-working chemically amplified radiation sensitive resin composition. Subsequently, a difference of resolution line widths of isolated and dense patterns, ΔCD was measured according to the "evaluation method for isolated and dense patterns" described above and a result of Table 1 was obtained.

### Example 2

The same manner was taken as Example 1 except making the amount of B-1 10.0 mole-% relative to C-1 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Example 3

The same manner was taken as Example 1 except making the amount of C-2 50.0 µmole/g of C-1 relative to A-1 and the amount of B-2 20.0 mole-% relative to C-2 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Example 4

The same manner was taken as Example 1 except replacing A-1 with A-2 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Example 5

The same manner was taken as Example 1 except replacing A-1 with A-3 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Example 6

The same manner was taken as Example 1 except replacing A-1 with A-4 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Comparative Example 1

The same manner was taken as Example 1 except not mixing B-1 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

### Comparative Example 2

The same manner was taken as Example 1 except replacing A-1 with A-5 to prepare a positive-working chemically amplified radiation sensitive resin composition. Then a difference of resolution line widths of isolated and dense patterns, ΔCD was measured according to the "evaluation method for isolated and dense patterns" and a result of Table 1 was obtained.

**Table-1**

| Evaluation of isolated and dense patterns | |
|---|---|
| | Difference of isolated and dense patterns, ΔCD (nm) |
| Example 1 | 8.1 |
| Example 2 | 17.0 |
| Example 3 | 7.9 |
| Example 4 | 8.5 |
| Example 5 | 18.3 |
| Example 6 | 19.4 |
| Comparative Example 1 | 25.0 |
| Comparative Example 2 | 26.6 |

As obviated by Table 1, the positive-working chemically amplified radiation sensitive resin composition of the present invention is able to restrain a difference of resolution line widths caused by a difference of isolated and dense patterns upon exposure with same exposure energy.

### Effectiveness of the Invention

As mentioned above in detail, the positive-working chemically amplified radiation sensitive resin composition having high sensitivity, high resolution and a small difference of resolution line widths of isolated and dense patterns can be offered by the present invention. As a result, the processing as designed can be made at a high accuracy and a high through-put in a fine processing when manufacturing electronic parts such as a semiconductor, three-dimensional fine structure, etc.

### Industrial Applicability

The present invention can be applied for a fine processing when manufacturing electronic parts such as a semiconductor, three-dimensional fine structure, etc.

## Claims

1. A positive-working chemically amplified radiation sensitive resin composition which comprises;
(A) an alkali-insoluble or slightly alkali-soluble resin protected with an acid-labile protecting group and made alkali-soluble by cleavage of said acid-labile protecting group, activation energy (ΔE) of which is 25 Kcal/mole or higher,
(B) a compound generating a carboxylic acid upon irradiation with radiation, and
(C) a compound generating a sulfonic acid upon irradiation with radiation.

2. The positive-working chemically amplified radiation sensitive resin composition according to claim 1, wherein the alkali-insoluble or slightly alkali-soluble resin protected with an acid-labile protecting group and made alkali-soluble upon cleavage of said acid-labile protecting group, activation energy(ΔE) of which is not less than 25 Kcal/mole comprises a t-butoxycarbonyl styrene, t-butoxystyrene or t-butyl(meth)acrylate unit.

3. The positive-working chemically amplified radiation sensitive resin composition according to claim 1 or 2, wherein the content of the compound generating a carboxylic acid upon irradiation with radiation is 1.0 to 100 mole-% relative to the content of the compound generating a sulfonic acid upon irradiation with radiation.

4. The positive-working chemically amplified radiation sensitive resin composition according to any one of claims 1 to 3, wherein the difference, ΔCD between a diameter of a contact hole with a designed line width of 0.18 µm in an isolated pattern and that in a dense pattern upon exposure in the optimum exposure dose by measurement under a scanning electronic microscope is 20 nm or less.
